# EUROPÄISCHE PATENTANMELDUNG

(11) **EP 4 679 690 A1**
(43) Veröffentlichungstag der Anmeldung: **14.01.2026**
(21) Anmeldenummer: 24187101.1
(22) Anmeldetag: 08.07.2024
(51) Int. Cl.: H02M 1/00

(54) **WECHSELRICHTER UND VERFAHREN ZUM ANSTEUERN EINES WECHSELRICHTERS**

(71) Anmelder: Siemens Aktiengesellschaft, 80333 München (DE)
(72) Erfinder: Gick, Sebastian, 96167 Königsfeld (DE); Bakran, Mark-Matthias, 91052 Erlangen (DE); Pfeifer, Markus, 90455 Nürnberg (DE)
(74) Vertreter: Siemens Patent Attorneys

(57) **Zusammenfassung**

Die Erfindung betrifft einen Wechselrichter (1). Der Wechselrichter (1) umfasst sechs Halbleiterschalter (T1, T2), die in einer B6-Topologie mit drei Halbbrücken (H1, H2, H3), die jeweils zwei der Halbleiterschalter (T1, T2) aufweisen, verschaltet sind, und eine Steuereinheit (5), die eingerichtet ist, die Halbleiterschalter (T1, T2) pulsweitenmoduliert anzusteuern. Alle Halbbrücken (H1, H2, H3) sind gleich ausgeführt. Jede Halbbrücke (H1, H2, H3) weist zwei voneinander verschiedene Halbleiterschalter (T1, T2) auf. Die Steuereinheit (5) ist eingerichtet, die beiden Halbleiterschalter (T1, T2) jeder Halbbrücke (H1, H2, H3) derart anzusteuern, dass die beiden Halbleiterschalter (T1, T2) unterschiedlich mit elektrischem Strom belastet werden, wenn eine Last des Wechselrichters (1) einen Lastschwellenwert unterschreitet.

## Beschreibung

Die Erfindung betrifft einen Wechselrichter mit sechs Halbleiterschaltern, die in einer B6-Topolo-gie mit drei Halbbrücken, die jeweils zwei der Halbleiterschalter aufweisen, verschaltet sind, und ein Verfahren zum Ansteuern eines derartigen Wechselrichters.

Ein derartiger Wechselrichter weist einen Gleichspannungszwischenkreis auf, wobei einer der Halbleiterschalter jeder Halbbrücke mit dem positiven Pol des Gleichspannungszwischenkreises verbunden ist und der andere Halbleiterschalter jeder Halbbrücke mit dem negativen Pol des Gleichspannungszwischenkreises verbunden ist. In der Vergangenheit wurden als Halbleiterschalter eines derartigen Wechselrichters vorwiegend Silizium-IGBTs (IGBT: Abkürzung für Insulated-Gate Bipolar Transistor, deutsch: Bipolartransistor mit isolierter Gate-Elektrode) verwendet, das heißt IGBTs mit Silizium als Halbleiter. In vielen Anwendungen werden statt Silizium-IGBTs nun beispielsweise Siliziumkarbid-MOSFETs (MOSFET: Abkürzung für Metal-Oxide-Semiconductor Field-Effect Transistor, deutsch: Metall-Oxid-Halbleiter-Feldeffekttransistor) verwendet, das heißt MOSFETs mit Siliziumkarbid als Halbleiter. Siliziumkarbid-MOSFETs werden vor allem in Anwendungen verwendet, die einen besonders hohen Wirkungsgrad erfordern. Eine derartige Anwendung ist die Elektromobilität, bei der Verluste im Wechselrichter mit einer Reichweitenverkürzung einhergehen. Allerdings sind Siliziumkarbid-MOSFETs teurer als Silizium-IGBTs. In kostensensitiven Anwendungen werden daher weiterhin vorwiegend IGBT-Wechselrichter eingesetzt, wobei der schlechtere Wirkungsgrad, den IGBTs vor allem in einem Teillastbetrieb des Wechselrichters aufweisen, in Kauf genommen wird. Es gibt daher eine Diskrepanz zwischen einer hohen Energieeffizienz (beziehungsweise einem hohen Wirkungsgrad) insbesondere im Teillastbetrieb und den Kosten eines Wechselrichters.

Bekannt und kommerziell verfügbar sind Silizium-IGBTs kombiniert mit Siliziumkarbid-Schottky-Dioden. Die Verlustersparnis liegt hier in den geringeren Schaltverlusten aufgrund der fehlenden Sperrverzögerungsladung (Reverse Recovery Charge) einer Siliziumkarbid-Schottky-Diode. Eine nennenswerte Reduktion von Leitverlusten im Teillastbetrieb eines Wechselrichters wird dadurch jedoch nicht erreicht. Eine Kombination von Silizium-IGBTs und Siliziumkarbid-Schottky-Dioden eignet sich daher vor allem für Wechselrichter mit hohen Schaltfrequenzen, ist allerdings nicht für Wechselrichter mit geringen Schaltfrequenzen sinnvoll.

Intensiv geforscht wird gegenwärtig an einer Verwendung von Hybridschaltern, bei denen parallel zu einem Silizium-IGBT mit einer antiparallel geschalteten Diode ein Siliziumkarbid-MOSFET geschaltet wird, siehe beispielsweise X. Song, A. Q. Huang, M.-C. Lee und C. Peng, "High voltage Si/SiC hybrid switch: An ideal next step for SiC," 2015 IEEE 27th International Symposium on Power Semiconductor Devices & IC's (ISPSD), 2015, DOI: 10.1109/ISPSD.2015.7123446 und R. E. Mathieson, P. D. Judge und S. Finney, "Si/SiC Hybrid Switch for Improved Switching and Part-Load Performance," 2020 IEEE 21st Workshop on Control and Modeling for Power Electronics (COMPEL), 2020, DOI: 10.1109/COMPEL49091.2020.9265711. Je nach Ausführungsform wird der Siliziumkarbid-MOSFET für Schaltvorgänge und für das Leiten geringer Ströme benutzt. Der IGBT wird für das Leiten großer Ströme benutzt. Je nach Ausführungsform ergibt sich aufgrund der fehlenden Schwellenspannung des Siliziumkarbid-MOSFET ein Leitverlustvorteil und aufgrund der besseren dynamischen Eigenschaften des Siliziumkarbid-MOSFET ein Schaltverlustvorteil. Der Leitverlustvorteil ist allerdings begrenzt, da der Siliziumkarbid-Flächenanteil in dieser Anordnung gering sein muss, um einen Kostenvorteil gegenüber einem Siliziumkarbid-MOSFET-B6-Wechselrichter zu erzielen. Außerdem gestalten sich die Ansteuerung und Auslegung der Halbleiterschalter komplex.

Der Erfindung liegt die Aufgabe zugrunde, einen relativ kostengünstigen Wechselrichter mit B6-Topologie anzugeben, der insbesondere in einem Teillastbetrieb des Wechselrichters einen hohen Wirkungsgrad aufweist.

Die Aufgabe wird erfindungsgemäß durch einen Wechselrichter mit den Merkmalen des Anspruchs 1 und ein Verfahren mit den Merkmalen des Anspruchs 9 gelöst.

Vorteilhafte Ausgestaltungen der Erfindung sind Gegenstand der Unteransprüche.

Ein erfindungsgemäßer Wechselrichter umfasst
- sechs Halbleiterschalter, die in einer B6-Topologie mit drei Halbbrücken, die jeweils zwei der Halbleiterschalter aufweisen, verschaltet sind, und
- eine Steuereinheit, die eingerichtet ist, die Halbleiterschalter pulsweitenmoduliert anzusteuern, wobei
- alle Halbbrücken gleich ausgeführt sind,
- jede Halbbrücke zwei voneinander verschiedene Halbleiterschalter aufweist und
- die Steuereinheit eingerichtet ist, die beiden Halbleiterschalter jeder Halbbrücke derart anzusteuern, dass die beiden Halbleiterschalter unterschiedlich mit elektrischem Strom belastet werden, wenn eine Last des Wechselrichters einen Lastschwellenwert unterschreitet.

Die Formulierung, dass die beiden Halbleiterschalter jeder Halbbrücke unterschiedlich mit elektrischem Strom belastet werden, ist so zu verstehen, dass sich die Summen der Einschaltdauern der beiden Halbleiterschalter (und somit die Summen der Zeitdauern, in denen die Halbleiterschalter Strom leiten) während eines großen Zeitraums, das heißt während eines Zeitraums, der eine große Anzahl von Perioden der Pulsweitenmodulation umfasst, deutlich voneinander unterscheiden.

Ein erfindungsgemäßer Wechselrichter weist also in jeder seiner Halbbrücken zwei verschiedene Halbleiterschalter auf. Dadurch wird eine Kombination kostengünstiger Halbleiterschalter und energieeffizienter Halbleiterschalter ermöglicht und somit ein Mittelweg zwischen einem Wechselrichter, der ausschließlich kostengünstige Halbleiterschalter mit einem relativ schlechten Wirkungsgrad im Teillastbetrieb aufweist, und einem Wechselrichter, der ausschließlich kostspielige Halbleiterschalter mit einem hohen Wirkungsgrad aufweist. Um den relativ schlechten Wirkungsgrad der kostengünstigen Halbleiterschalter im Teillastbetrieb teilweise zu kompensieren, sieht die Erfindung eine unterschiedliche Belastung der beiden Halbleiterschalter einer Halbbrücke mit elektrischem Strom bei kleinen Lasten des Wechselrichters, nämlich bei Lasten unterhalb eines Lastschwellenwerts, vor. So kann die Belastung der kostengünstigen Halbleiterschalter mit elektrischem Strom gegenüber der Belastung der Halbleiterschalter mit einem hohen Wirkungsgrad im Teillastbetrieb reduziert werden. Dies erhöht im Teillastbetrieb durch eine Reduzierung der Schalt- und Leitverluste den Wirkungsgrad des Wechselrichters gegenüber einer gleichmäßigen Belastung der beiden Halbleiterschalter einer Halbbrücke. Der Lastschwellenwert, unterhalb dessen die Halbleiterschalter jeder Halbbrücke unterschiedlich stark mit elektrischem Strom belastet werden, wird geeignet in Abhängigkeit von den verwendeten Halbleiterschaltern gewählt, so dass unterhalb des Lastschwellenwerts eine deutliche Verbesserung des Wirkungsgrades des Wechselrichters durch die unterschiedliche Belastung der Halbleiterschalter gegenüber einer gleichmäßigen Belastung der Halbleiterschalter erzielt wird.

Bei hohen Lasten (und somit hohen Strömen) des Wechselrichters werden hingegen die beiden Halbleiterschalter einer Halbbrücke gleichmäßig mit elektrischem Strom belastet, da eine höhere Belastung der Halbleiterschalter mit einem hohen Wirkungsgrad gegenüber der Belastung der kostengünstigen Halbleiterschalter bei hohen Lasten des Wechselrichters zu einer starken Erwärmung der Halbleiterschalter mit einem hohen Wirkungsgrad führen würde. Außerdem unterscheiden sich die Wirkungsgrade kostengünstiger Halbleiterschalter bei hohen Lasten des Wechselrichters weit weniger von den Wirkungsgraden kostspieliger Halbleiterschalter als bei geringen Lasten des Wechselrichters, so dass bei hohen Lasten eine unterschiedliche Belastung der Halbleiterschalter keine wesentliche Verbesserung des Wirkungsgrades des Wechselrichters bewirkt.

Die Ansteuerung eines Wechselrichters, der kostengünstige Halbleiterschalter und Halbleiterschalter mit einem hohen Wirkungsgrad aufweist, unterscheidet sich nicht von der Ansteuerung eines Wechselrichters, der nur kostengünstige Halbleiterschalter aufweist, so dass der Treiberaufwand für beide Wechselrichter gleich ist. Darüber hinaus erlaubt die Verwendung verschiedener Halbleiterschalter eine Veränderung der Leitverluste des Wechselrichters durch die Variation der Ansteuerung der Halbleiterschalter. Bei Verwendung nur eines Halbleiterschaltertyps wäre das nicht möglich.

Bei einer Ausgestaltung des erfindungsgemäßen Wechselrichters weist ein Halbleiterschalter jeder Halbbrücke einen Halbleiter mit breitem Bandabstand auf und der andere Halbleiterschalter jeder Halbbrücke ist ein Silizium-IGBT, zu dem eine Diode antiparallel geschaltet ist. Beispielsweise sind die Halbleiterschalter, die einen Halbleiter mit breitem Bandabstand aufweisen, Siliziumkarbid-MOSFETs oder Siliziumkarbid-JFETs (JFET: Abkürzung für Junction Field-Effect Transistor, deutsch: Sperrschicht-Feldeffekttransistor). Halbleiterschalter, die einen Halbleiter mit breitem Bandabstand aufweisen, weisen vorteilhaft besonders hohe Wirkungsgrade durch geringe Schalt- und Leitverluste auf.

Bei einer weiteren Ausgestaltung des erfindungsgemäßen Wechselrichters weist ein Halbleiterschalter jeder Halbbrücke einen selbstleitenden Halbleiter auf. Selbstleitende Halbleiter weisen geringere Leitverluste und eine erhöhte Robustheit gegenüber selbstsperrenden Halbleitern auf. Beispiele hierfür sind der Siliziumkarbid-JFET im Vergleich zum Siliziumkarbid-MOSFET oder der D-mode Galliumnitrid-HEMT im Vergleich zum E-Mode Galliumnitrid-HEMT (HEMT: Abkürzung für High-Electron-Mobility Transistor, deutsch: Transistor mit hoher Elektronenbeweglichkeit).

Bei einer weiteren Ausgestaltung des erfindungsgemäßen Wechselrichters ist ein Halbleiterschalter jeder Halbbrücke als ein unipolarer Transistor ausgebildet und der andere Halbleiterschalter jeder Halbbrücke ist als ein bipolarer Transistor ausgebildet. Die Steuereinheit ist dann vorzugsweise eingerichtet, die beiden Halbleiterschalter jeder Halbbrücke derart anzusteuern, dass der als ein unipolarer Transistor ausgebildete Halbleiterschalter stärker mit elektrischem Strom belastet wird als der als ein bipolarer Transistor ausgebildete Halbleiterschalter, wenn die Last des Wechselrichters den Lastschwellenwert unterschreitet. Dies berücksichtigt, dass ein unipolarer Transistor im Teillastbetrieb geringere Schaltverluste als ein bipolarer Transistor aufweist.

Bei einer weiteren Ausgestaltung des erfindungsgemäßen Wechselrichters ist die Steuereinheit eingerichtet, die Ansteuerung der Halbleiterschalter aus einer Raumzeigermodulation abzuleiten, wobei, wenn die Last des Wechselrichters den Lastschwellenwert unterschreitet, als Nullspannungsraumzeiger wenigstens überwiegend derjenige Nullspannungsraumzeiger ausgegeben wird, bei dem die als unipolare Transistoren ausgebildeten Halbleiterschalter eingeschaltet sind. Die Formulierung, dass überwiegend ein bestimmter Nullspannungsraumzeiger ausgegeben wird, bedeutet, dass dieser Nullspannungsraumzeiger während einer Periode der Pulsweitenmodulation länger ausgegeben wird als der andere Nullspannungsraumzeiger. Die überwiegende Ausgabe desjenigen Nullspannungsraumzeigers, bei dem die als unipolare Transistoren ausgebildeten Halbleiterschalter eingeschaltet sind, impliziert, dass die als unipolare Transistoren ausgebildeten Halbleiterschalter stärker mit elektrischem Strom belastet werden als die als bipolare Transistoren ausgebildeten Halbleiterschalter.

Bei einer weiteren Ausgestaltung des erfindungsgemäßen Wechselrichters ist die Steuereinheit eingerichtet, die Ansteuerung der Halbleiterschalter jeder Halbbrücke aus einer Sinusfunktion abzuleiten, deren Funktionswerte im Fall, dass die Last des Wechselrichters den Lastschwellenwert unterschreitet, um einen Offsetwert derart verschoben werden, dass der als ein unipolarer Transistor ausgebildete Halbleiterschalter der Halbbrücke stärker mit elektrischem Strom belastet wird als der als ein bipolarer Transistor ausgebildete Halbleiterschalter der Halbbrücke. Die Sinusfunktion wird beispielsweise durch eine Sinusspannung realisiert, die sinusförmig von der Zeit abhängt. Bei der Ableitung der Ansteuerung der Halbleiterschalter einer Halbbrücke wird die Sinusfunktion (Sinusspannung) wie üblich mit einer periodischen Vergleichsfunktion (Vergleichsspannung), beispielsweise mit einer Sägezahnfunktion verglichen, wobei die Periode der Sinusfunktion deutlich größer als die Periode der Vergleichsfunktion ist und der Graph der Vergleichsfunktion symmetrisch unter einer Drehung um 180 Grad um einen Punkt auf der Abszissenachse ist. In Zeitbereichen, in denen die Vergleichsfunktion größer als die Sinusfunktion ist, wird das Ansteuersignal der Pulsweitenmodulation auf den Wert 1 gesetzt, in den anderen Zeitbereichen wird das Ansteuersignal auf den Wert 0 gesetzt (oder umgekehrt; es wird hier von einem normierten Ansteuersignal der Pulsweitenmodulation ausgegangen, das nur die Werte 0 und 1 annimmt, was jedoch unwesentlich ist). Bei Verwendung einer Sinusfunktion ohne eine Verschiebung der Funktionswerte ist die Gesamtzeit (das heißt die Summe der Zeitbereiche), in der das Ansteuersignal den Wert 1 annimmt, während jeder Periode der Sinusfunktion gleich der Gesamtzeit, in denen das Ansteuersignal den Wert 0 annimmt. Durch eine Verschiebung der Funktionswerte der Sinusfunktion um einen Offsetwert werden die beiden Gesamtzeiten relativ zueinander geändert, so dass eine dieser Gesamtzeiten größer als die andere Gesamtzeit wird. Der Unterschied zwischen den Gesamtzeiten wächst mit wachsendem Offsetwert bis die Maxima der Sinusfunktion und die Maxima der Vergleichsfunktion oder die Minima der Sinusfunktion und die Minima der Vergleichsfunktion gleiche Werte annehmen. Durch die Verschiebung der Sinusfunktion um den Offsetwert kann daher ebenfalls eine ungleichmäßige Belastung der beiden Halbleiterschalter einer Halbbrücke mit elektrischem Strom erreicht werden, wobei der Unterschied der dieser Belastungen durch den Offsetwert eingestellt werden kann.

Bei dem erfindungsgemäßen Verfahren wird ein Wechselrichter angesteuert, der sechs Halbleiterschalter aufweist, die in einer B6-Topologie mit drei gleich ausgeführten Halbbrücken verschaltet sind, die jeweils zwei voneinander verschiedene Halbleiterschalter aufweisen. Bei dem Verfahren werden die beiden Halbleiterschalter jeder Halbbrücke derart angesteuert, dass die beiden Halbleiterschalter unterschiedlich mit elektrischem Strom belastet werden, wenn eine Last des Wechselrichters einen Lastschwellenwert unterschreitet.

Eine Ausgestaltung des erfindungsgemäßen Verfahrens betrifft einen Wechselrichter, bei dem ein Halbleiterschalter jeder Halbbrücke als ein unipolarer Transistor ausgebildet ist und der andere Halbleiterschalter jeder Halbbrücke als ein bipolarer Transistor ausgebildet ist. Der als ein unipolarer Transistor ausgebildete Halbleiterschalter jeder Halbbrücke wird stärker mit elektrischem Strom belastet als der als ein bipolarer Transistor ausgebildete Halbleiterschalter, wenn die Last des Wechselrichters den Lastschwellenwert unterschreitet.

Bei einer weiteren Ausgestaltung des erfindungsgemäßen Verfahrens wird die Ansteuerung der Halbleiterschalter aus einer Raumzeigermodulation abgeleitet, wobei, wenn die Last des Wechselrichters den Lastschwellenwert unterschreitet, als Nullspannungsraumzeiger wenigstens überwiegend derjenige Nullspannungsraumzeiger ausgegeben wird, bei dem die als unipolare Transistoren ausgebildeten Halbleiterschalter eingeschaltet sind.

Bei einer weiteren Ausgestaltung des erfindungsgemäßen Verfahrens wird die Ansteuerung der Halbleiterschalter jeder Halbbrücke aus einer Sinusfunktion abgeleitet, deren Funktionswerte im Fall, dass die Last des Wechselrichters den Lastschwellenwert unterschreitet, um einen Offsetwert derart verschoben werden, dass der als ein unipolarer Transistor ausgebildete Halbleiterschalter der Halbbrücke stärker mit elektrischem Strom belastet wird als der als ein bipolarer Transistor ausgebildete Halbleiterschalter der Halbbrücke.

Die Merkmale des erfindungsgemäßen Verfahrens entsprechen oben genannten Merkmalen eines erfindungsgemäßen Wechselrichters. Daher entsprechen auch die Vorteile des erfindungsgemäßen Verfahrens oben bereits genannten Merkmalen eines erfindungsgemäßen Wechselrichters.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
FIG 1 einen Schaltplan eines Ausführungsbeispiels eines Wechselrichters,
FIG 2 aus einer Raumzeigermodulation abgeleitete Ansteuersignale für Halbleiterschalter eines Wechselrichters während einer Periode einer Pulsweitenmodulation in einem ersten Betriebsmodus des in Figur 1 gezeigten Wechselrichters,
FIG 3 aus einer Raumzeigermodulation abgeleitete Ansteuersignale für Halbleiterschalter eines Wechselrichters während einer Periode einer Pulsweitenmodulation in einem zweiten Betriebsmodus des in Figur 1 gezeigten Wechselrichters,
FIG 4 aus einer Sinusfunktion abgeleitete Ansteuersignale für Halbleiterschalter eines Wechselrichters während einer Periode der Sinusfunktion in einem ersten Betriebsmodus des in Figur 1 gezeigten Wechselrichters,
FIG 5 aus einer durch einen Offsetwert verschobenen Sinusfunktion abgeleitete Ansteuersignale für Halbleiterschalter eines Wechselrichters während einer Periode der Sinusfunktion in einem zweiten Betriebsmodus des in Figur 1 gezeigten Wechselrichters,
FIG 6 ein Diagramm für simulierte Wirkungsgrade verschiedener Wechselrichter in Abhängigkeit von einem Verhältnis eines Drehmoments zu einem Nenndrehmoment für 10% einer Motornenndrehzahl eines mit dem jeweiligen Wechselrichter betriebenen Motors, wobei der Wirkungsgrad des in Figur 1 gezeigten Wechselrichters für zwei Betriebsmodi gezeigt ist,
FIG 7 ein Diagramm für simulierte Wirkungsgrade verschiedener Wechselrichter in Abhängigkeit von einem Verhältnis eines Drehmoments zu einem Nenndrehmoment für 100% einer Motornenndrehzahl eines mit dem jeweiligen Wechselrichter betriebenen Motors, wobei der Wirkungsgrad des in Figur 1 gezeigten Wechselrichters für zwei Betriebsmodi gezeigt ist.

Einander entsprechende Teile sind in den Figuren mit denselben Bezugszeichen versehen.

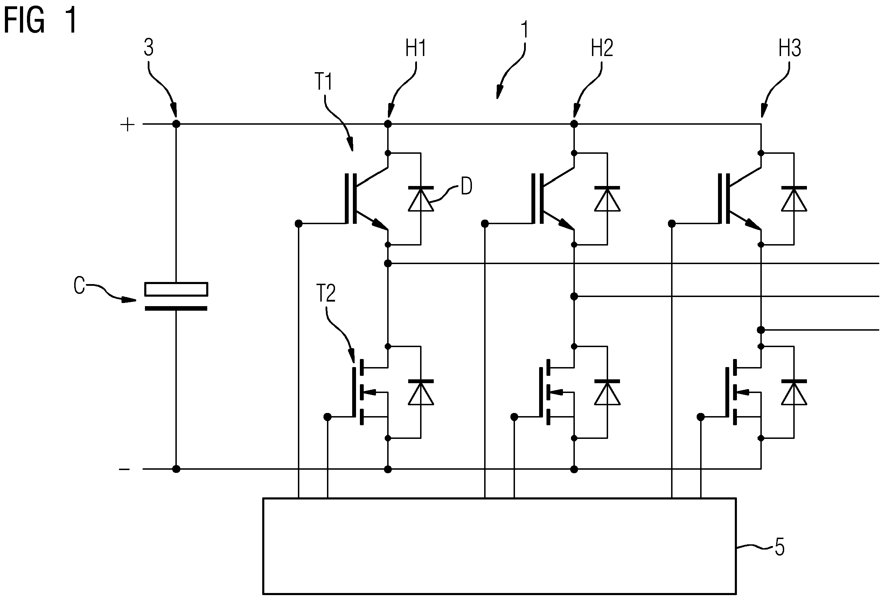

Figur 1 (FIG 1) zeigt einen Schaltplan eines Ausführungsbeispiels eines Wechselrichters 1 mit einer B6-Topologie. Der Wechselrichter 1 umfasst drei Halbbrücken H1, H2, H3, die jeweils zwei Halbleiterschalter T1, T2 aufweisen, einen Gleichspannungszwischenkreis 3 mit einem Kondensator C und eine Steuereinheit 5.

Alle Halbbrücken H1, H2, H3 sind gleich ausgeführt. Ein erster Halbleiterschalter T1 jeder Halbbrücke H1, H2, H3 und eine erste Elektrode des Kondensators C sind mit dem positiven Pol des Gleichspannungszwischenkreis 3 verbunden. Der zweite Halbleiterschalter T2 jeder Halbbrücke H1, H2, H3 und eine zweite Elektrode des Kondensators C sind mit dem negativen Pol des Gleichspannungszwischenkreis 3 verbunden.

Die ersten Halbleiterschalter T1 aller Halbbrücken H1, H2, H3 dieses Ausführungsbeispiels eines Wechselrichters 1 sind jeweils als ein Silizium-IGBT ausgebildet. Elektrisch antiparallel zu jedem ersten Halbleiterschalter T1 ist eine Diode D geschaltet. Die zweiten Halbleiterschalter T2 aller Halbbrücken H1, H2, H3 dieses Ausführungsbeispiels eines Wechselrichters 1 sind jeweils als ein Siliziumkarbit-MOSFET ausgebildet. Die in Figur 1 dargestellten Dioden, die jeweils elektrisch antiparallel zu einem zweiten Halbleiterschalter T2 geschaltet sind, sind in diesem Ausführungsbeispiel keine separaten elektrischen Bauelemente sondern jeweils die intrinsische so genannte Body-Diode eines Siliziumkarbit-MOSFET, die auch als Inversdiode bezeichnet wird. Bei anderen Ausführungsbeispielen können die Halbleiterschalter T1, T2 anders ausgeführt sein. Beispielsweise kann statt eines Siliziumkarbit-MOSFET jeweils ein Siliziumkarbit-JFET verwendet werden. Für die Erfindung ist irrelevant, mit welchem Pol des Gleichspannungszwischenkreises 3 die Silizium-IGBTs und die Siliziumkarbit-MOSFETs jeweils verbunden sind, das heißt bei einem anderem Ausführungsbeispiel können die Silizium-IGBTs jeweils mit dem negativen Pol des Gleichspannungszwischenkreises 3 verbunden sein und die Siliziumkarbit-MOSFETs jeweils mit dem positiven Pol.

Die Steuereinheit 5 ist eingerichtet, die Halbleiterschalter T1, T2 pulsweitenmoduliert anzusteuern, und zu diesem Zweck mit einem Steueranschluss (Gate-Anschluss) jedes Halbleiterschalters T1, T2 verbunden. Dabei ist die Steuereinheit 5 eingerichtet, die beiden Halbleiterschalter T1, T2 jeder Halbbrücke H1, H2, H3 derart anzusteuern, dass die beiden Halbleiterschalter T1, T2 unterschiedlich mit elektrischem Strom belastet werden, wenn eine Last des Wechselrichters 1 einen Lastschwellenwert unterschreitet. Dabei werden bei diesem Ausführungsbeispiel die zweiten Halbleiterschalter T2 stärker mit elektrischem Strom belastet als die ersten Halbleiterschalter T1, wenn die Last des Wechselrichters 1 den Lastschwellenwert unterschreitet. Der Stärke der Belastung der zweiten Halbleiterschalter T2 mit elektrischem Strom relativ zu der Belastung der ersten Halbleiterschalter T1 kann dabei mit abnehmender Last des Wechselrichters 1 zunehmen.

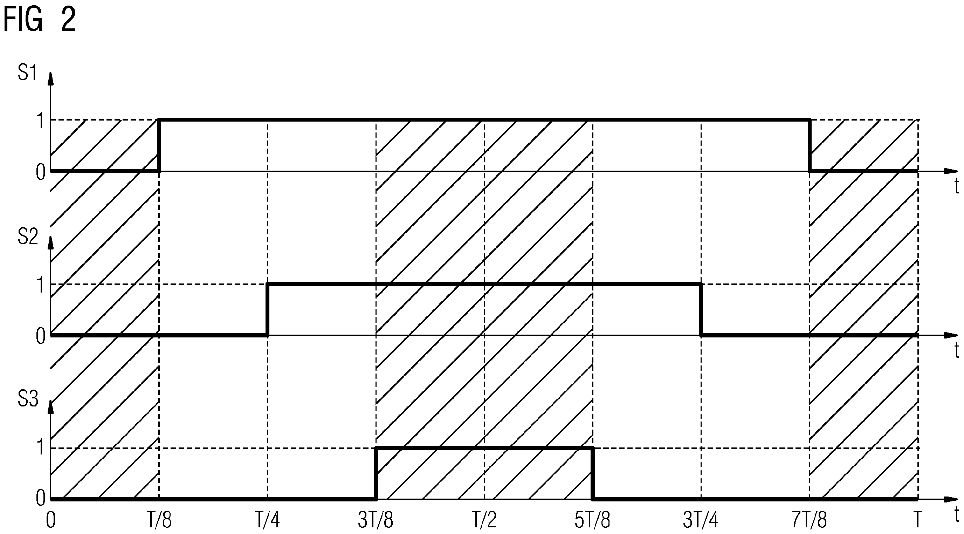

Der Betrieb des Wechselrichters 1 mit gleicher Belastung der beiden Halbleiterschalter T1, T2 jeder Halbbrücke H1, H2, H3 mit elektrischem Strom wird im Folgenden als ein erster Betriebsmodus des Wechselrichters 1 bezeichnet. Der Betrieb des Wechselrichters 1 mit voneinander verschiedenen Belastungen der beiden Halbleiterschalter T1, T2 jeder Halbbrücke H1, H2, H3 mit elektrischem Strom wird im Folgenden als ein zweiter Betriebsmodus des Wechselrichters 1 bezeichnet. Verschiedene Realisierungen (Ausführungsbeispiele) dieser Betriebsmodi werden im Folgenden anhand der Figuren 2 bis 5 beschrieben.

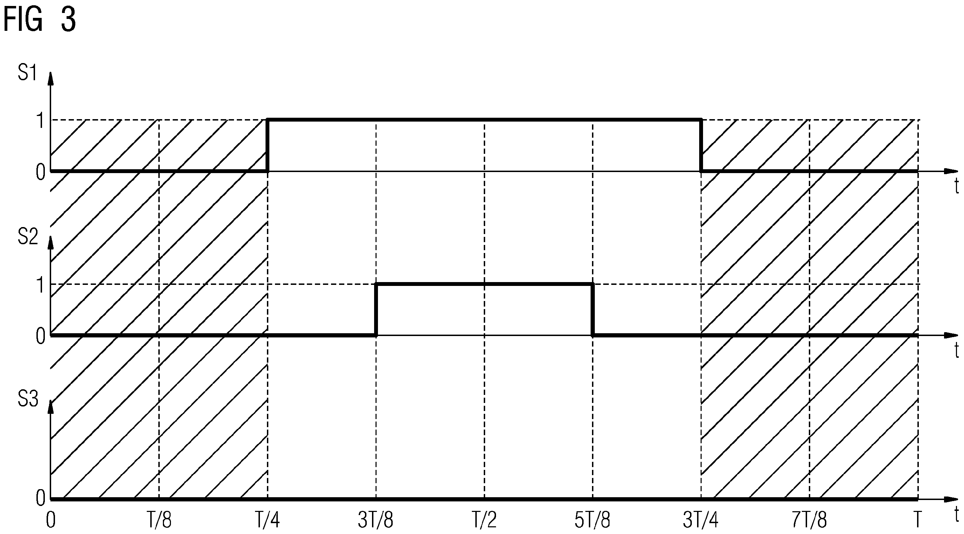

Figur 2 (FIG 2) und Figur 3 (FIG 3) illustrieren eine Realisierung der beiden Betriebsmodi, bei der die Ansteuerung der Halbleiterschalter T1, T2 aus einer Raumzeigermodulation abgeleitet wird. Die Figuren 2 und 3 zeigen Ansteuersignale S1, S2, S2 der Pulsweitenmodulation in Abhängigkeit von einer Zeit t während einer Periode T der Pulsweitenmodulation für die Halbleiterschalter T1, T2 jeweils einer Halbbrücke H1 H2, H3 des Wechselrichters 1. S1 ist das Ansteuersignal für die Halbleiterschalter T1, T2 der Halbbrücke H1. Wenn das Ansteuersignal S1 den Wert 1 annimmt, ist der Halbleiterschalter T1 der ersten Halbbrücke H1 eingeschaltet (geschlossen) und der Halbleiterschalter T2 der Halbbrücke H1 ist ausgeschaltet (geöffnet). Wenn das Ansteuersignal S1 den Wert 0 annimmt, ist der Halbleiterschalter T1 der ersten Halbbrücke H1 ausgeschaltet (geöffnet) und der Halbleiterschalter T2 der Halbbrücke H1 ist eingeschaltet (geschlossen). Entsprechendes gilt für die Halbleiterschalter T1, T2 der beiden anderen Halbbrücke H2, H3, wobei S2 das Ansteuersignal für die Halbleiterschalter T1, T2 der Halbbrücke H2 ist und S3 das Ansteuersignal für die Halbleiterschalter T1, T2 der Halbbrücke H3 ist.

Nullspannungsraumzeiger der Raumzeigermodulation bewirken gleiche Schaltzustände der ersten Halbleiterschalter T1 aller drei Halbbrücken H1, H2, H3 (und demensprechend auch gleiche Schaltzustände der zweiten Halbleiterschalter T2 aller drei Halbbrücke H1, H2, H3). Es gibt zwei Nullspannungsraumzeiger. Ein erster Nullspannungsraumzeiger bewirkt, dass alle Ansteuersignale S1, S2, S2 gleichzeitig den Wert 1 annehmen. Dies ist in Figur 2 zwischen den Zeitpunkten t=3T/8 und t=5T/8 der Fall. Ein zweiter Nullspannungsraumzeiger bewirkt, dass alle Ansteuersignale S1, S2, S2 gleichzeitig den Wert 0 annehmen. Dies ist in Figur 2 zwischen den Zeitpunkten t=0 und t=T/8 und zwischen den Zeitpunkten t=7T/8 und t=T der Fall. Insgesamt werden in Figur 2 beide Nullspannungsraumzeiger während einer Periode T der Pulsweitenmodulation dieselbe Gesamtzeitdauer ausgegeben. In Figur 3 werden dagegen gleiche Schaltzustände der ersten Halbleiterschalter T1 aller drei Halbbrücken H1, H2, H3 nur angenommen, wenn alle Ansteuersignale S1, S2, S2 gleichzeitig den Wert 0 annehmen. Dies ist in Figur 3 zwischen den Zeitpunkten t=0 und t=T/4 und zwischen den Zeitpunkten t=3T/4 und t=T der Fall.

Figur 2 illustriert den ersten Betriebsmodus des Wechselrichters 1 bei einer Ableitung durch eine Raumzeigermodulation. Dieser Betriebsmodus wird dadurch realisiert, dass beide Nullspannungsraumzeiger während jeder Periode T der Pulsweitenmodulation für dieselben Gesamtzeitdauern ausgegeben werden.

Figur 3 illustriert den zweiten Betriebsmodus des Wechselrichters 1 bei einer Ableitung durch eine Raumzeigermodulation. Dieser Betriebsmodus wird dadurch realisiert, dass die beiden Nullspannungsraumzeiger während jeder Periode T der Pulsweitenmodulation für voneinander verschiedene Gesamtzeitdauern ausgegeben werden. In Figur 3 ist der Extremfall gezeigt, dass während jeder Periode T der Pulsweitenmodulation nur einer der beiden Nullspannungsraumzeiger ausgegeben wird, nämlich der Nullspannungsraumzeiger, der ein gleichzeitiges Einschalten der zweiten Halbleiterschalter T2 und ein gleichzeitiges Ausschalten der Halbleiterschalter T1 aller drei Halbbrücken H1, H2, H3 bewirkt. Bei dem in Figur 3 gezeigten Beispiel werden die zweiten Halbleiterschalter T2 insgesamt länger eingeschaltet als die ersten Halbleiterschalter T1 und daher auch stärker mit elektrischem Strom belastet als die ersten Halbleiterschalter T1.

Natürlich gibt es auch Modulationen, in denen die beiden Nullspannungsraumzeiger während einer Periode T der Pulsweitenmodulation unterschiedlich lange ausgegeben werden, ohne dass einer der beiden Nullspannungsraumzeiger gar nicht ausgegeben wird. Solche Modulationen können beispielsweise für einen schrittweisen Übergang von der Modulation, bei der wie in Figur 3 nur ein Nullspannungsraumzeiger ausgegeben wird, zu der Modulation, bei dem wie in Figur 2 beide Nullspannungsraumzeiger gleichlange ausgegeben werden, verwendet werden.

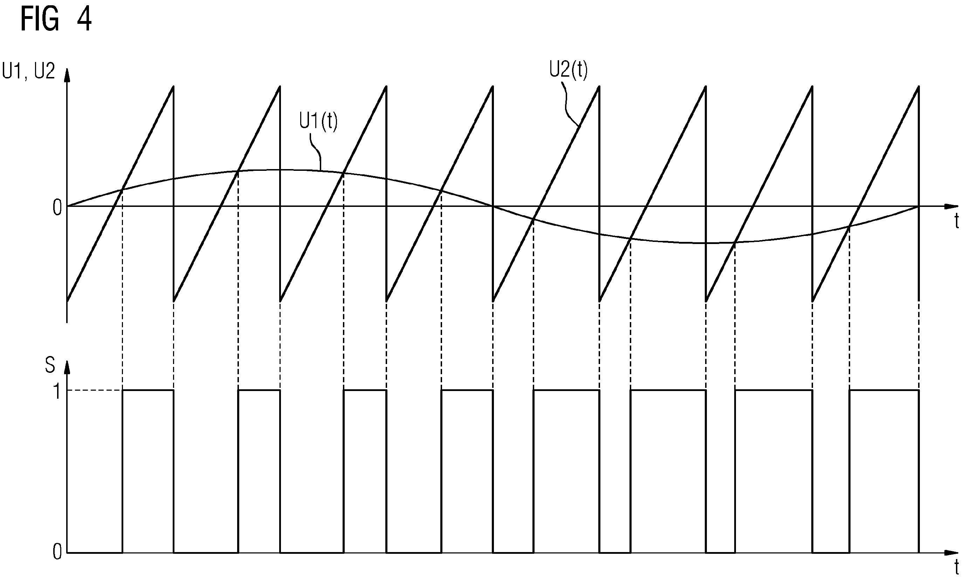

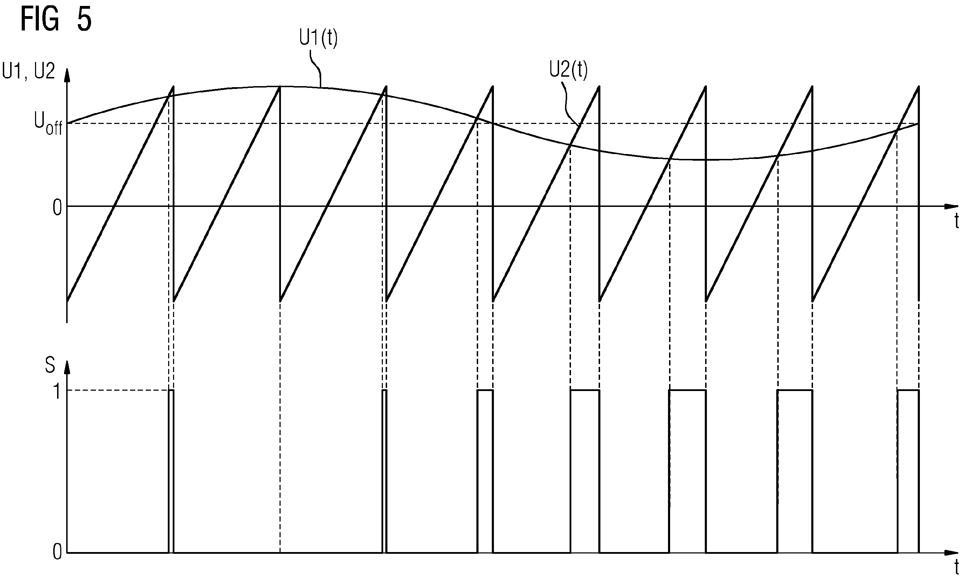

Figur 4 (FIG 4) und Figur 5 (FIG 5) illustrieren eine Realisierung der beiden Betriebsmodi, bei der die Ansteuerung der beiden Halbleiterschalter T1, T2 jeder Halbbrücken H1, H2, H3 aus einer Sinusfunktion U1(t) abgeleitet wird, die als eine Sinusspannung U1 in Abhängigkeit von einer Zeit t realisiert ist.

Figur 4 zeigt die Realisierung des ersten Betriebsmodus. Die Sinusfunktion U1(t) wird mit einer periodischen Sägezahnfunktion U2(t) verglichen, die ebenfalls als eine Spannung U2 in Abhängigkeit von der Zeit t realisiert ist. Dabei ist die Periode der Sinusfunktion U1(t) deutlich (in diesem Beispiel achtmal) größer als die Periode der Sägezahnfunktion U2(t), die die Periode der Pulsweitenmodulation ist, und die Sägezahnfunktion U2(t) weist betragsmäßig gleichgroße Extrema mit positiven und negativen Funktionswerten auf. In Zeitbereichen, in denen die Sägezahnfunktion U2(t) größer als die Sinusfunktion U1(t) ist, wird ein Ansteuersignal S der Pulsweitenmodulation für die Halbleiterschalter T1, T2 auf den Wert 1 gesetzt, in den anderen Zeitbereichen wird das Ansteuersignal auf den Wert 0 gesetzt. Die Gesamtzeit (das heißt die Summe der Zeitbereiche), in der das Ansteuersignal den Wert 1 annimmt, ist während jeder Periode der Sinusfunktion gleich der Gesamtzeit, in der das Ansteuersignal S den Wert 0 annimmt. Die beiden durch das Ansteuersignal S angesteuerten Halbleiterschalter T1, T2 werden daher während jeder Periode der Sinusfunktion U1(t) gleichlang eingeschaltet und somit in gleicher Stärke mit elektrischem Strom belastet.

Figur 5 zeigt die Realisierung des zweiten Betriebsmodus. Gegenüber dem ersten Betriebsmodus wird die Sinusfunktion U1(t) (beziehungsweise deren Funktionswerte) um einen positiven Offsetwert U_{off} (beziehungsweise eine Offsetspannung U_{off}) verschoben, während die Sägezahnfunktion U2(t) nicht verschoben wird. Durch die Verschiebung der Sinusfunktion U1(t) ändern sich die Zeitbereiche, in denen die Sägezahnfunktion U2(t) größer als die Sinusfunktion U1(t) ist. Dadurch ändern sich auch die Zeitbereiche, in denen das Ansteuersignal S den Wert 0 annimmt, und zwar so, dass die Gesamtzeit (das heißt die Summe der Zeitbereiche), in der das Ansteuersignal S den Wert 0 annimmt, während jeder Periode der Sinusfunktion U1(t) größer ist als die Gesamtzeit, in der das Ansteuersignal S den Wert 1 annimmt. Dadurch wird der zweite Halbleiterschalter T2 während jeder Periode der Sinusfunktion U1(t) länger eingeschaltet und somit stärker mit elektrischem Strom belastet als der erste Halbleiterschalter T1. Der Unterschied zwischen der Gesamtzeit, in der das Ansteuersignal S den Wert 0 annimmt, und der Gesamtzeit, in der das Ansteuersignal S den Wert 1 annimmt, wächst mit wachsendem Offsetwert U_{off} bis die Maxima der Sinusfunktion U1(t) und die Maxima der Sägezahnfunktion U2(t) denselben Wert annehmen. Der Unterschied der Belastungen der Halbleiterschalter T1, T2 mit elektrischem Strom kann daher durch den Offsetwert U_{off} eingestellt werden.

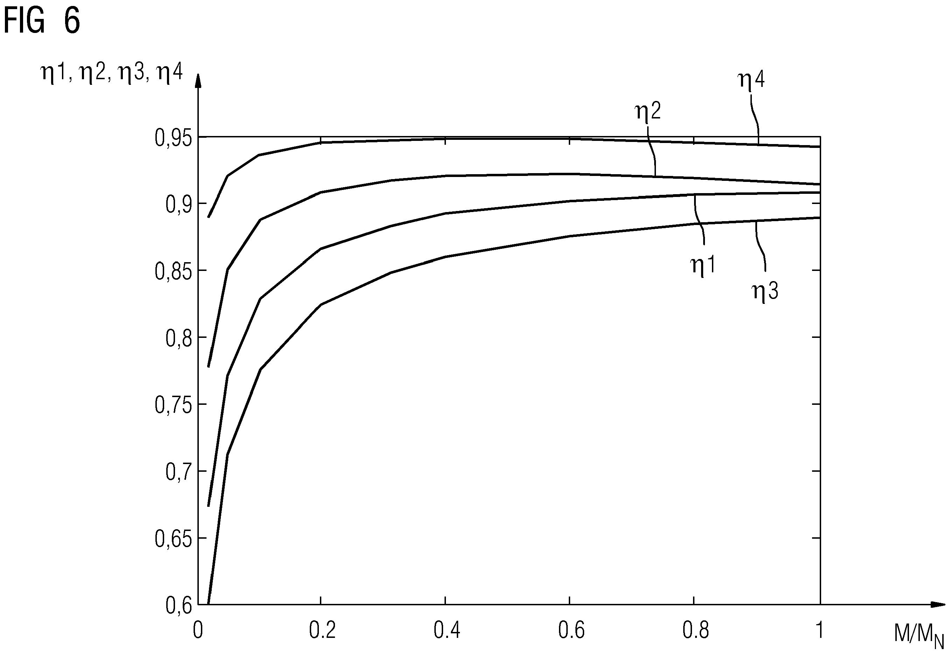

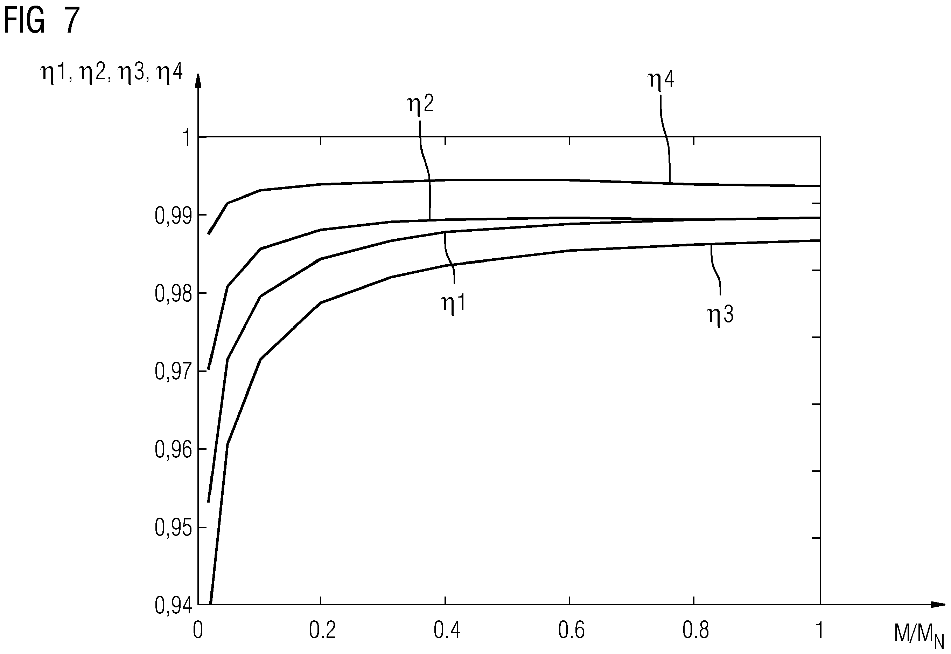

Die Figuren 6 und 7 zeigen jeweils ein Diagramm für simulierte Wirkungsgrade η1 bis η4 verschiedener Wechselrichter in Abhängigkeit von einem Verhältnis M/M_{N} eines Drehmoments M zu einem Nenndrehmoment M_{N} eines mit dem jeweiligen Wechselrichter betriebenen Motors, wobei ein Wirkungsgrad η1, η2 des in Figur 1 gezeigten Wechselrichters 1 für jeden der beiden oben beschriebenen Betriebsmodi gezeigt ist. Figur 6 zeigt die Wirkungsgrade η1 bis η4 für 10% einer Motornenndrehzahl, das heißt in einem Teillastbetrieb der Wechselrichter. Figur 7 zeigt die Wirkungsgrade η1 bis η4 für 100% einer Motornenndrehzahl, das heißt in einem Volllastbetrieb der Wechselrichter.

η1 bezeichnet den Wirkungsgrad des in Figur 1 gezeigten Wechselrichters 1 für dessen ersten Betriebsmodus. η2 bezeichnet den Wirkungsgrad des in Figur 1 gezeigten Wechselrichters 1 für dessen zweiten Betriebsmodus. η3 bezeichnet den Wirkungsgrad eines Wechselrichters, der ausschließlich Silizium-IGBTs als Halbleiterschalter aufweist. η4 bezeichnet den Wirkungsgrad eines Wechselrichters, der ausschließlich Siliziumkarbit-MOSFETs als Halbleiterschalter aufweist.

Figur 6 zeigt, dass sich im Teillastbetrieb die Wirkungsgrade η1 bis η4 deutlich voneinander unterscheiden, wobei der Wirkungsgrad η4 des Wechselrichters, der ausschließlich Siliziumkarbit-MOSFETs als Halbleiterschalter aufweist, am größten ist, gefolgt von dem Wirkungsgrad η2 des in Figur 1 gezeigten Wechselrichters 1 in dessen zweitem Betriebsmodus, dem Wirkungsgrad η1 des in Figur 1 gezeigten Wechselrichters 1 in dessen erstem Betriebsmodus und dem Wirkungsgrad η3 des Wechselrichters, der ausschließlich Silizium-IGBTs als Halbleiterschalter aufweist. Insbesondere weist der in Figur 1 gezeigte Wechselrichter 1 im Teillastbetrieb in dessen zweitem Betriebsmodus, insbesondere für kleine Werte des Verhältnisses M/M_{N}, einen deutlich höheren Wirkungsgrad η2 als in dessen erstem Betriebsmodus auf.

Figur 6 und Figur 7 zeigen ferner, dass die Unterschiede der Wirkungsgrade η1 bis η4 der Wechselrichter im Volllastbetrieb deutlich geringer sind als im Teillastbetrieb (man beachte, dass in Figur 7 auf der Ordinatenachse Werte der Wirkungsgrade η1 bis η4 zwischen 0,94 und 1 aufgetragen sind, in Figur 6 jedoch Werte zwischen 0,6 und 0,95). Insbesondere zeigt Figur 7, dass sich die Wirkungsgrade η1 und η2 des in Figur 1 gezeigten Wechselrichters 1 in dessen beiden Betriebsmodi im Volllastbetrieb kaum voneinander unterscheiden. Der zweite Betriebsmodus des in Figur 1 gezeigten Wechselrichters 1 ist daher nur in einem Teillastbetrieb unterhalb eines geeignet gewählten Lastschwellenwertes deutlich effektiver als der erste Betriebsmodus.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

Unabhängig vom grammatikalischen Geschlecht eines bestimmten Begriffes sind Personen mit männlicher, weiblicher oder anderer Geschlechteridentität mit umfasst.

## Patentansprüche

1. Wechselrichter (1), umfassend
- sechs Halbleiterschalter (T1, T2), die in einer B6-Topologie mit drei Halbbrücken (H1, H2, H3), die jeweils zwei der Halbleiterschalter (T1, T2) aufweisen, verschaltet sind, und
- eine Steuereinheit (5), die eingerichtet ist, die Halbleiterschalter (T1, T2) pulsweitenmoduliert anzusteuern, wobei
- alle Halbbrücken (H1, H2, H3) gleich ausgeführt sind,
- jede Halbbrücke (H1, H2, H3) zwei voneinander verschiedene Halbleiterschalter (T1, T2) aufweist und
- die Steuereinheit (5) eingerichtet ist, die beiden Halbleiterschalter (T1, T2) jeder Halbbrücke (H1, H2, H3) derart anzusteuern, dass die beiden Halbleiterschalter (T1, T2) unterschiedlich mit elektrischem Strom belastet werden, wenn eine Last des Wechselrichters (1) einen Lastschwellenwert unterschreitet.

2. Wechselrichter (1) nach Anspruch 1, wobei ein Halbleiterschalter (T2) jeder Halbbrücke (H1, H2, H3) einen Halbleiter mit breitem Bandabstand aufweist und der andere Halbleiterschalter (T1) jeder Halbbrücke (H1, H2, H3) ein Silizium-IGBT ist, zu dem eine Diode (D) antiparallel geschaltet ist.

3. Wechselrichter (1) nach Anspruch 2, wobei die Halbleiterschalter (T2), die einen Halbleiter mit breitem Bandabstand aufweisen, Siliziumkarbid-MOSFETs oder Siliziumkarbit-JFETs sind.

4. Wechselrichter (1) nach einem der vorhergehenden Ansprüche, wobei ein Halbleiterschalter (T1, T2) jeder Halbbrücke (H1, H2, H3) einen selbstleitenden Halbleiter aufweist.

5. Wechselrichter (1) nach einem der vorhergehenden Ansprüche, wobei ein Halbleiterschalter (T2) jeder Halbbrücke (H1, H2, H3) als ein unipolarer Transistor ausgebildet ist und der andere Halbleiterschalter (T1) jeder Halbbrücke (H1, H2, H3) als ein bipolarer Transistor ausgebildet ist.

6. Wechselrichter (1) nach Anspruch 5, wobei die Steuereinheit (5) eingerichtet ist, die beiden Halbleiterschalter (T1, T2) jeder Halbbrücke (H1, H2, H3) derart anzusteuern, dass der als ein unipolarer Transistor ausgebildete Halbleiterschalter (T2) stärker mit elektrischem Strom belastet wird als der als ein bipolarer Transistor ausgebildete Halbleiterschalter (T1), wenn die Last des Wechselrichters (1) den Lastschwellenwert unterschreitet.

7. Wechselrichter (1) nach Anspruch 5 oder 6, wobei die Steuereinheit (5) eingerichtet ist, die Ansteuerung der Halbleiterschalter (T1, T2) aus einer Raumzeigermodulation abzuleiten, wobei, wenn die Last des Wechselrichters (1) den Lastschwellenwert unterschreitet, als Nullspannungsraumzeiger wenigstens überwiegend derjenige Nullspannungsraumzeiger ausgegeben wird, bei dem die als unipolare Transistoren ausgebildeten Halbleiterschalter (T2) eingeschaltet sind.

8. Wechselrichter (1) nach Anspruch 5 oder 6, wobei die Steuereinheit (5) eingerichtet ist, die Ansteuerung der Halbleiterschalter (T1, T2) jeder Halbbrücke (H1, H2, H3) aus einer Sinusfunktion U1(1) abzuleiten, deren Funktionswerte im Fall, dass die Last des Wechselrichters (1) den Lastschwellenwert unterschreitet, um einen Offsetwert U_{off} derart verschoben werden, dass der als ein unipolarer Transistor ausgebildete Halbleiterschalter (T2) der Halbbrücke (H1, H2, H3) stärker mit elektrischem Strom belastet wird als der als ein bipolarer Transistor ausgebildete Halbleiterschalter (T1) der Halbbrücke (H1, H2, H3).

9. Verfahren zum Ansteuern eines Wechselrichters (1), der sechs Halbleiterschalter (T1, T2) aufweist, die in einer B6-Topologie mit drei gleich ausgeführten Halbbrücken (H1, H2, H3) verschaltet sind, die jeweils zwei voneinander verschiedene Halbleiterschalter (T1, T2) aufweisen, wobei die beiden Halbleiterschalter (T1, T2) jeder Halbbrücke (H1, H2, H3) derart angesteuert werden, dass die beiden Halbleiterschalter (T1, T2) unterschiedlich mit elektrischem Strom belastet werden, wenn eine Last des Wechselrichters (1) einen Lastschwellenwert unterschreitet.

10. Verfahren nach Anspruch 9, wobei ein Halbleiterschalter (T2) jeder Halbbrücke (H1, H2, H3) als ein unipolarer Transistor ausgebildet ist und der andere Halbleiterschalter (T1) jeder Halbbrücke (H1, H2, H3) als ein bipolarer Transistor ausgebildet ist und der als ein unipolarer Transistor ausgebildete Halbleiterschalter (T2) stärker mit elektrischem Strom belastet wird als der als ein bipolarer Transistor ausgebildete Halbleiterschalter (T1), wenn die Last des Wechselrichters (1) den Lastschwellenwert unterschreitet.

11. Verfahren nach Anspruch 10, wobei die Ansteuerung der Halbleiterschalter (T1, T2) aus einer Raumzeigermodulation abgeleitet wird, wobei, wenn die Last des Wechselrichters (1) den Lastschwellenwert unterschreitet, als Nullspannungsraumzeiger wenigstens überwiegend derjenige Nullspannungsraumzeiger ausgegeben wird, bei dem die als unipolare Transistoren ausgebildeten Halbleiterschalter (T2) eingeschaltet sind.

12. Verfahren nach Anspruch 10, wobei die Ansteuerung der Halbleiterschalter (T1, T2) jeder Halbbrücke (H1, H2, H3) aus einer Sinusfunktion U1(t) abgeleitet wird, deren Funktionswerte im Fall, dass die Last des Wechselrichters (1) den Lastschwellenwert unterschreitet, um einen Offsetwert U_{off} derart verschoben werden, dass der als ein unipolarer Transistor ausgebildete Halbleiterschalter (T2) der Halbbrücke (H1, H2, H3) stärker mit elektrischem Strom belastet wird als der als ein bipolarer Transistor ausgebildete Halbleiterschalter (T1) der Halbbrücke (H1, H2, H3).
